(19) Europäisches Patentamt
European Patent Office
Office européen des brevets

(11) Veröffentlichungsnummer: **0 333 012 B1**

(12) **EUROPÄISCHE PATENTSCHRIFT**

(45) Veröffentlichungstag der Patentschrift: **20.10.93**

(51) Int. Cl.⁵: **G03F 7/095**, G03F 7/11

(21) Anmeldenummer: **89104091.7**

(22) Anmeldetag: **08.03.89**

# (54) Lichtempfindliche, photopolymerisierbare Druckplatte.

(30) Priorität: **17.03.88 DE 3808952**

(43) Veröffentlichungstag der Anmeldung:
**20.09.89 Patentblatt 89/38**

(45) Bekanntmachung des Hinweises auf die Patenterteilung:
**20.10.93 Patentblatt 93/42**

(84) Benannte Vertragsstaaten:
**BE CH DE FR GB IT LI NL**

(56) Entgegenhaltungen:
**EP-A- 0 128 014**
**DE-A- 1 447 029**

**CHEMICAL ABSTRACTS, Band 90, Nr. 6, 5. Februar 1979, page 29, Abstract Nr. 39669h, Columbus, Ohio, US;& JP-A-53106786**

**CHEMICAL ABSTRACTS, Band 96, Nr. 26, 28. Juni 1982, page 632, Abstract Nr. 226603t, Columbus, Ohio, US;& JP-A-81154731**

**PATENT ABSTRACTS OF JAPAN, Band 8, Nr. 27 (P-252)[1464], 4. Februar 1984;& JP-A-58 181 039**

(73) Patentinhaber: **BASF Aktiengesellschaft**
**Carl-Bosch-Strasse 38**
**D-67063 Ludwigshafen(DE)**

(72) Erfinder: **Huemmer, Wolfgang, Dr.**
**Vischerstrasse 16**
**D-6703 Limburgerhof(DE)**
Erfinder: **Bronstert, Bernd, Dr.**
**Zanderstrasse 35**
**D-6701 Otterstadt(DE)**
Erfinder: **Littmann, Dieter, Dr.**
**Schulstrasse 10**
**D-6717 Hessheim(DE)**
Erfinder: **Zuerger, Manfred**
**Holderlandstrasse 2**
**D-6920 Sinsheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services
(3.10/3.6/3.3.1)

## Beschreibung

Die Erfindung betrifft eine lichtempfindliche, photopolymerisierbare zur Herstellung von Druckformen geeignete Druckplatte, die auf einem dimensionsstabilen Träger mindestens eine Zwischenschicht und darauf eine reliefbildende lichtempfindliche, photopolymerisierbare Schicht trägt, die im wesentlichen aus einem Gemisch aus polymerem Bindemittel, mindestens einer ethylenisch ungesättigten polymerisierbaren Verbindung, Photoinitiator und einem Inhibitor gegen die thermische Polymerisation besteht, sowie ein Verfahren zur Herstellung derartiger lichtempfindlicher Druckplatten.

Lichtempfindliche Mehrschichtenmaterialien, die zwischen Trägerschicht und reliefbildender lichtempfindlicher Schicht spezielle Haftschichten aufweisen, sind bereits bekannt. So ist z.B. aus der DE-A-22 02 357 bekannt, photopolymere Reliefschichten für Druckformen durch spezielle Haftschichten auf den Trägerschichten fest zu verankern, wobei nach Beschichten der Träger, z.B. der Stahl- oder Aluminiumbleche, mit einer Grundierlackschicht (HG) zur verbesserten Haftung mit der reliefbildenden lichtempfindlichen Schicht eine Haftschicht HO durch schichtförmiges Auftragen und Trocknen bzw. Einbrennen eines Lackes (OL) hergestellt wird, der eine härtbare Mischung eines Bindemittels enthält, das mit dem polymeren Bindemittel der reliefbildenden Schicht verträglich ist. Für das Einbrennen bzw. Härten der Haftschichten HO ist jedoch die Anwendung hoher Temperaturen erforderlich, was einerseits einen hohen Energieaufwand mit entsprechend hohen Herstellkosten bedeutet, andererseits die Verwendung mancher Trägermaterialien nicht gestattet, da sie die Wärmebehandlung ohne starke Beeinträchtigung ihrer Eigenschaften nicht überstehen. Dies gilt z.B. für die Herstellung von photopolymeren Druckplatten mit Polyesterfolien als Trägerschichten. Es ist zwar bekannt, die Härtungstemperatur von härtbaren Formaldehyd-Harzen durch Zugabe von Säuren als Katalysatoren herabzusetzen, doch eignen sich solche katalysierten Harze wegen ihrer geringen Topfzeit nicht zur Herstellung gleichmäßiger Lackierungen und einheitlicher dünner Haftschichten.

Aus der DE-A-30 45 515 ist ein lichtempfindliches Mehrschichtenmaterial bekannt, das zwischen einer gegebenenfalls mit einer Grundierlackschicht (HG) versehenen Trägerschicht (T) und einer lichtempfindlichen Schicht (R) mit einer Photoinitiator enthaltenden Mischung von mindestens einem Bindemittel und mindestens einer damit verträglichen ethylenisch ungesättigten Verbindung eine der lichtempfindlichen Schicht R benachbarte Haftschicht HO mit einer gehärteten Mischung aus 65 bis 98 Gew.% eines mit dem Bindemittel der Schicht R und dem Kondensat (AZ) verträglichen Bindemittels (A1) und 2 bis 35 Gew.% eines bei 60 bis 120 °C ohne Säurekatalyse härtbaren 1 bis 5 Melamin-Einheiten enthaltenden Melamin-Formaldehyd-Kondensats mit einem Methylolierungsgrad des Melamins von 40 bis 100 %, wobei 10 bis 60 % der Methylolgruppen mit Alkohol verethert sind, enthält.

Aus der EP-A-00 36 301 ist ein lichtempfindliches Polyamidharzgemisch aus alkohollöslichem Polyamid, einer nicht polymeren Verbindung, die in ein und demselben Molekül sowohl Vinyl- als auch Epoxygruppen aufweist und mit dem polymeren Bindemittel unter Bildung copolymerisationsfähiger Polymerer reagieren kann sowie einem polyfunktionellen Vinylmonomeren mit

$$-O-CH_2-\underset{\displaystyle OH}{\underset{|}{CH}}-CH_2-O-CO-CR=CH_2-\text{Gruppierungen},$$

darunter auch Phenylglycidyletheracrylat als weichmachende Komponente, mit polyfunktionellen Acrylaten kombiniert, in photopolymerisierbaren Druckplatten, die alkohollösliches modifiziertes Polyamid als polymeres Bindemittel enthalten, beschrieben. Es wird hier also als weichmachende Komponente in der Reliefschicht eingesetzt.

In der DE-A-14 47 029 wird ein dünnes, elastisches, photopolymerisierbares Element zur Herstellung von Druckplatten mit flachem Relief beschrieben, das Haft- und Zwischenschichten enthält, die jedoch nicht Verbindungen der allgemeinen Formel (I) gemäß der vorliegenden Anmeldung in im wesentlichen ausgehärteten Zustand enthalten.

Aufgabe der vorliegenden Erfindung ist es, lichtempfindliche, photopolymerisierbare Druckplatten aufzuzeigen, die sowohl eine verbesserte Haftung der Reliefschicht auf dem Trägermaterial als auch eine verkürzte Mindestbelichtungszeit bei der Herstellung der Druckformen aus diesen Druckplatten aufweisen.

Überraschenderweise läßt sich diese Aufgabe dadurch sehr vorteilhaft lösen, daß man Zwischenschichten verwendet, die bestimmte Arylglycidylether(meth)acrylate in zumindest teilweise polymerisierten Zustand enthalten bzw. daraus bestehen.

Gegenstand der vorliegenden Erfindung ist eine lichtempfindliche, photopolymerisierbare, zur Herstellung von Druckformen geeignete Druckplatte, die auf einem dimensionsstabilen Träger mindestens eine

Zwischenschicht und darauf eine reliefbildende lichtempfindliche Schicht trägt, die im wesentlichen aus einem Gemisch aus polymerem Bindemittel, mindestens einer ethylenisch ungesättigten polymerisierbaren Verbindung, Photoinitiator und thermischem Polymerisationsinhibitor besteht, die dadurch gekennzeichnet ist, daß mindestens eine Zwischenschicht eine Verbindung der allgemeinen Formel (I)

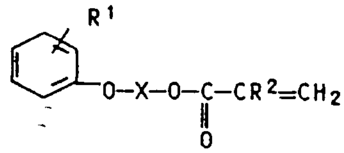 (I)

worin $R^1$ für Wasserstoff oder einen Alkylrest mit 1 bis 10 Kohlenstoffatomen,
$R^2$ für Wasserstoff oder einen Methylrest,
und X für
$-C_2H_4-$, $-(CH_2-CH_2-O)_n-C_2H_4-$ ,
$-(CHCH_3-CH_2-O)_n-CHCH_3-CH_2-$ ,

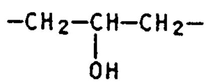 oder 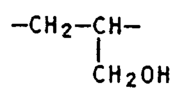

und n = 1 bis 8 stehen, in im wesentlichen ausgehärteten Zustand enthält.

Dabei kann auf dem dimensionsstabilen Träger als erste Zwischenschicht eine dünne Schicht eines üblichen Haftvermittlers und darauf eine zweite Zwischenschicht vorhanden sein, die eine Verbindung der allgemeinen Formel (I) im Gemisch mit polymerem Bindemittel in im wesentlichen ausgehärteten Zustand enthält, oder eine Zwischenschicht kann aus einer Verbindung der allgemeinen Formel (I) in im wesentlichen ausgehärteten Zustand bestehen.

Eine vorteilhafte Ausgestaltung der Erfindung besteht darin, daß mindestens eine Zwischenschicht aus einem Gemisch einer Verbindung der allgemeinen Formel (I) mit einem damit verträglichen polymeren Bindemittel besteht, wobei die Verbindung der allgemeinen Formel (I) in im wesentlichen ausgehärteten Zustand vorliegt und als polymeres Bindemittel, insbesondere Polyvinylalkohol, ein Derivat des Polyvinylalkohols, ein Polyamid oder ein Ethylen/(Meth)acrylsäureester/(Meth)acrylsäure-Copolymerisat eingesetzt wird.

Die lichtempfindliche Schicht der erfindungsgemäßen Druckplatte kann in üblicher Weise mit einer abziehbaren Schutzfolie bedeckt sein.

Gegenstand der vorliegenden Erfindung ist außerdem ein Verfahren zur Herstellung einer lichtempfindlichen photopolymerisierbaren Druckplatte, wobei eine Lösung, die eine Verbindung der allgemeinen Formel (I) enthält, als Zwischenschicht auf den dimensionsstabilen Träger aufgetragen, nach weitgehender Entfernung des Lösungsmittels die das Relief bildende lichtempfindliche Schicht aufgebracht und dann der erhaltene Schichtaufbau solange vollflächig belichtet wird, daß die Zwischenschicht im wesentlichen aushärtet, ohne daß die in der das Relief bildende Schicht enthaltenen ethylenisch ungesättigten polymerisierbaren Verbindungen im wesentlichen Umfang polymerisieren.

Die erfindungsgemäßen, bzw. die nach dem erfindungsgemäßen Verfahren hergestellten lichtempfindlichen, photopolymerisierbaren Druckplatten zeichnen sich durch eine verbesserte Haftung, eine wesentlich verbesserte Resistenz gegenüber dem Entwickler und eine höhere Auflagenfestigkeit aus.

Zu den Aufbaukomponenten der erfindungsgemäßen Druckplatten und die für das erfindungsgemäße Verfahren einzusetzenden Materialien ist im einzelnen folgendes auszuführen.

Als erfindungsgemäß einzusetzende Verbindungen der allgemeinen Formel (I)

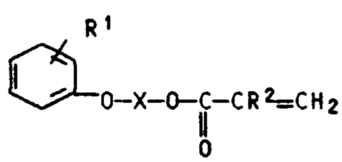 (I)

kommen solche in Frage, in denen $R^1$ für Wasserstoff, einen Alkylrest mit 1 bis 10 Kohlenstoffatomen oder einen Arylrest mit 6 bis
10 Kohlenstoffatomen,
$R^2$ für Wasserstoff oder einen Methylrest,
und X für
$-C_2H_4-$ ,
$-(CH_2-CH_2-O)_n-C_2H_4-$ ,
$-(CHCH_3-CH_2-O)_n-CHCH_3-CH_2-$ ,

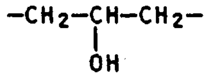 oder 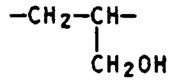

und n = 1 bis 8 stehen.

Als $R^1$ kommt außer Wasserstoff beispielsweise ein Alkylrest mit 1 bis 10 Kohlenstoffatomen, wie z.B. ein Methyl-, Ethyl-, n-Propyl-, Isopropyl-, n-Butyl-, Isobutyl-, tert.-Butyl-, Hexyl-, n-Oktyl-, Isooctylrest oder ein Arylrest, wie z.B. ein Phenyl- oder Naphthylrest in Frage.

Bevorzugt sind solche Verbindungen der Formel (I), in denen $R^1$ für Wasserstoff oder Methyl und X für den Rest

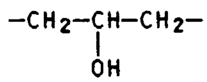

stehen.

Als dimensionsstabile Träger eignen sich die für die Herstellung photopolymerer Druckformen üblicherweise verwendeten, beispielsweise Stahlbleche, Aluminiumbleche, Kunststoffolien, wie z.B. solche aus Polyestern, wie Polyethylenterephthalat, Polycarbonat, Polyvinylchlorid oder Polyamid.

Es kann vorteilhaft sein, den dimensionsstabilen Träger zunächst mit einer Grundierlackschicht zu versehen. Hierfür lassen sich verschiedene Grundierlackschichten verwenden, soweit diese eine hinreichende Haftung zwischen Trägermaterial und der darauf anzubringenden Zwischen- bzw. Haftschicht vermitteln und, soweit erforderlich, bei Temperaturen getrocknet bzw. eingebrannt werden können, bei denen die Eigenschaften des Trägermaterials thermisch nicht geschädigt werden.

Als meist sehr geeignet erwiesen sich pigmentierte und unpigmentierte Grundierlackschichten, die aus Reaktivlacken hergestellt wurden, die Polyisocyanate und hydroxylgruppenhaltige Oliogomere und Polymere wie hydroxylgruppenhaltige Epoxidharze und/oder hydroxylgruppenhaltige Polyester (bevorzugt mit Molekulargewichten von 20 000 bis 30 000) oder deren Mischungen mit anderen Polyolen, z.B. 1,4-Butandiol, enthalten. Zur Herstellung der Grundierlackschicht wird z.B. der fertig abgemischte Grundierlack mit einem Feststoffgehalt von 20 - 70 Gew.%, auf den dimensionsstabilen Träger in einer solchen Stärke aufgebracht, daß eine Trockenschichtstärke von 3 - 100 µm, vorzugsweise 5 - 20 µm erzielt wird. Die Beschichtung kann mit Hilfe einer der üblichen Techniken wie Streichen, Spritzen, Tauchen, Gießen oder Walzenauftrag erfolgen. Danach kann die Beschichtung je nach Trägermaterial bei Temperaturen zwischen 50 und 300 °C getrocknet werden bzw. eingebrannnt werden.

Zur Herstellung der Zwischen- bzw. Haftschicht auf dem dimensionsstabilen Träger oder dem mit einer Grundierlackschicht versehenen dimensionsstabilen Träger wird eine Verbindung der allgemeinen Formel (I) oder deren Gemisch mit einem damit verträglichen polymeren Bindemittel sowie gegebenenfalls weiteren Zusätzen, zweckmäßigerweise in Form ihrer Lösung in solchen Schichtdicken aufgetragen, daß sich eine Trockenfilmstärke von 3 bis 25 µm, insbesondere 5 bis 15 µm einstellt. Diese Beschichtung kann ebenfalls durch Streichen, Spritzen, Tauchen, Gießen oder Walzenauftrag erfolgen.

Als polymere Bindemittel, die gegebenenfalls im Gemisch mit einer Verbindung der allgemeinen Formel (I) eingesetzt werden können, kommen in Frage:
wasserlösliche Copolymere oder Derivate des Polyvinylalkohols, beispielsweise in wäßrigen Lösungsmitteln lösliche oder dispergierbare elastomere Pfropfpolymerisate, die durch Polymerisation von Vinylestern in Gegenwart von Polyalkylenoxiden und einem Initiator der radikalischen Polymerisation, Verseifen oder Teilverseifen des resultierenden Pfropfcopolymerisats und gegebenenfalls anschließendes Verestern oder Umestern von Vinylalkohol-Einheiten des verseiften oder teilverseiften Pfropfcopolymerisats hergestellt sind

und im wesentlichen bestehen aus Struktureinheiten der Zusammensetzung

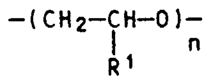

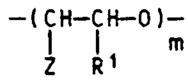

,

worin Z: aufgepfropfte Seitenzweige mit Struktureinheiten

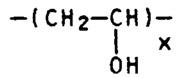

und ggf.

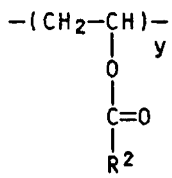

,

$R^1$ Wasserstoff und/oder Alkylreste mit 1 oder 2 C-Atomen,
$R^2$ Alkyl- und/oder Alkenylreste, gegebenenfalls mit Carboxylsubstituenten, darstellen,
und $x > y$, $n > m$, m mindestens 2, $n + m = 20\text{-}2000$, und

$$\frac{(n+m)}{(x+y)} = \frac{1}{4} \text{ bis } \frac{3}{1}$$

sind, wie sie in EP-A-224 164 beschrieben sind.

Ebenso eignen sich mit Methacrylsäure teilweise veresterte Polyvinylalkohole, wie sie in EP-A-220 507 bzw. DE-A-33 22 993 beschrieben sind, sowie teilacetalisierter Polyvinylalkohol. Derartige geeignete Polyvinylalkohole weisen im allgemeinen Molekulargewichte $\overline{M}_n$ zwischen etwa 4 000 und 100 000, vorzugsweise 10 000 und 70 000 auf;
Polyamide, wie z.B. Copolyamide, wie sie in DE-A-15 22 463 beschrieben sind, beispielsweise Copolyamide aus etwa gleichen Teilen Hexamethylendiammoniumadipat, 4,4'-Diammonium-di-cyclohexyl-methan-adipat und $\epsilon$-Caprolactam, die K-Werte (nach Fikentscher, Cellulosechemie 13 (1932) 58) von 55 bis 75 aufweisen;
carboxylgruppenhaltige Copolymerisate, insbesondere derartige Acrylatharze, beispielsweise solche auf Basis von Copolymerisaten von (Meth)acrylsäureestern mit (Meth)acrylsäure die Säurezahlen zwischen 30 und 100, Molekulargewichte ($\overline{M}_w$) von etwa 10.000 bis etwa 100.000 und Glastemperaturen zwischen 30 und 80 °C aufweisen, beispielsweise handelsübliche Produkte, wie Carboset®resin XL 44 der Fa. BF Goodrich;
außerdem Ethylen/(Meth)acrylsäureester/(Meth)acrylsäure-Copolymerisate, beispielsweise solche mit MFI-(Melt-Flow-Index; gemessen in g/10 Minuten bei 190 °C und 2,16 kg Belastung)-Werten zwischen 50 und 400 und Säurezahlen zwischen 50 und 200 mg KOH/g.

Die polymeren Bindemittel können in den Zwischenschichten im allgemeinen in Mengen von 0 bis 90, vorzugsweise 35 bis 80 Gew.%, bezogen auf das Gesamtgewicht der lösungsmittelfreien Zwischenschicht vorhanden sein.

Als weitere Bestandteile zur Herstellung der Zwischen- bzw. Haftschicht kommen in Frage Photoinitiatoren oder Photoinitiatorsysteme, Inhibitoren gegen die thermische Polymerisation, Lösungsmittel, wäßrige oder organische Lösungsmittelgemische sowie Zusätze zur Erzielung besonderer Effekte, beispielsweise

Glyoxal oder Glutardialdehyd.

Photoinitiatoren sind im allgemeinen in Mengen von 0,01 bis 10 und insbesondere 0,01 bis 3 Gew.%, bezogen auf die Gesamtmenge der Zwischenschicht vorhanden. Als Photoinitiatoren sind dabei solche Verbindungen geeignet, die bei Einwirkung von aktinischem Licht Radikale zu bilden vermögen und eine rasche Photopolymerisation in der Schicht auslösen. Als Photoinitiatoren kommen z.B. in Frage Acyloine und Acyloinether, aromatische Diketone und deren Derivate und mehrkernige Chinone. Sehr geeignet sind Benzoin- und $\alpha$-Hydroxymethylbenzoin und besonders deren Alkylether mit 1 bis 8 C-Atomen wie Benzoin-isopropylether, $\alpha$-Hydroxymethyl-benzoinmethylether oder Benzoinmethylether, Benzilmonoketale wie Benzil-dimethylketal, Benzil-methyl-ethylketal, Benzil-methyl-benzylketal, Benzil-neopentylketal oder Diarylphosphinoxide, wie sie in der DE-OS 29 09 992 beschrieben sind, vorzugsweise 2,6-Dimethoxybenzoyldiphenylphosphinoxid und insbesondere 2,4,6-Trimethylbenzoyl-diphenylphosphinoxid. Bevorzugt sind Photoinitiatoren in Art und Menge, daß sie für die Auslösung der Photopolymerisation bei bildmäßiger Belichtung mit aktinischem Licht, insbesondere UV-Licht. nur kurze Mindestbelichtungszeiten, bevorzugt nicht mehr als wenige Minuten, benötigen.

Die erfindungsgemäßen photopolymerisierbaren Zwischenschichten enthalten außerdem zweckmäßigerweise auch Inhibitoren gegen die thermische Polymerisation, wie Hydrochinon, p-Methoxyphenol, Dinitrobenzol, p-Chinon. Methylenblau, ,$\beta$-Naphthol, N-Nitrosamine wie N-Nitrosodiphenylamin, Phenothiazin, Phosphorigsäureester wie Triphenylphosphit oder die Salze und insbesondere die Alkali- und Aluminiumsalze des N-Nitroso-cyclohexyl-hydroxylamins. Die Inhibitoren werden den photopolymerisierbaren Mischungen der reliefbildenden polymerisierbaren Schicht im allgemeinen in einer Menge von 0,001 bis 3 Gew.% und insbesondere in einer Menge von 0,003 bis 1 Gew.%, bezogen auf die Gesamtmenge der polymerisierbaren Schicht, zugemischt.

In bekannter Weise können natürlich auch weitere übliche Zusätze mitverwendet werden, wie Weichmachner, gesättigte niedermolekulare Verbindungen mit Amid- oder Alkoholgruppen, Wachse, lösliche Farbstoffe, Pigmente usw.

Nach dem Auftragen der Zwischenschicht auf den gegebenenfalls mit einer Grundierlackschicht versehenen dimensionsstabilen Träger, erfolgt im allgemeinen nach Entfernung von gegebenenfalls vorhandenem Lösungsmittel durch Abdunsten oder Trocknen eine vollflächige Belichtung der Zwischenschicht mit aktinischem Licht, um die Verbindung der allgemeinen Formel (I) zumindest teilweise, vorzugsweise überwiegend in den polymeren Zustand überzufuhren.

Eine weitere Möglichkeit besteht darin, nach Auftrag der Zwischenschicht und Entfernung des Lösungsmittels unmittelbar die photopolymerisierbare reliefbildende Schicht auf die Zwischenschicht aufzutragen und dann den erhaltenen Schichtaufbau solange vollflächig zu belichten, daß zwar die in der reliefbildenden Schicht enthaltenen ethylenisch ungesättigten polymerisierbaren Verbindungen noch nicht oder nicht in wesentlichem Umfang polymerisieren, die Zwischenschicht aber zumindest teilweise - in den polymerisierten Zustand überführt wird. Die Belichtung kann bei transparenten Trägern auch von der Rückseite her erfolgen.

Eine weitere Möglichkeit, die Zwischenschicht in den polymerisierten Zustand zu überführen, besteht in einer thermisch ausgelösten Polymerisation, wobei typische Initiatoren der radikalischen Polymerisation, z.B. organische Peroxide, wie Benzoylperoxid, oder labile Azoverbindungen, wie Azodiisobutyronitril zugegen sein können. Dieses Verfahren eignet sich insbesondere bei metallischen Trägermaterialien, die die erforderlichen hohen Temperaturen (in der Regel über 100 °C) ohne Verlust der Dimensionsstabilität vertragen.

Die reliefbildende Schicht wird im allgemeinen vorteilhafterweise auf die Zwischen- oder Haftschicht aufkaschiert, wobei das Kaschierlösungsmittel von den polymeren Bindemitteln in der reliefbildenden Schicht bestimmt wird. Die Kaschierung kann auch ohne Lösungsmittel, z.B. als Heißkaschierung erfolgen.

Als polymere Bindemittel für die lichtempfindliche reliefbildende Schicht eignen sich praktisch alle in der Literatur für die Herstellung photopolymerer Druckplatten oder Reliefformen angegebenen Polymerbindemittel. Genannt seien Polyamide und besonders alkohollösliche Copolyamide, wie sie in der FR-PS 1 520 856 beschrieben sind, Cellulosederivate, insbesondere wäßrig-alkalisch auswaschbare Cellulosederivate, Vinylalkohol-Polymere und Polymere und Copolymere von Vinylestern aliphatischer Monocarbonsäuren mit 1 bis 4 C-Atomen, wie von Vinylacetat, mit unterschiedlichem Verseifungsgrad, Homo- und Copolymerisate des Vinylpyrrolidons, Polyurethane, Polyetherurethane, Polyesterurethane, Polyesterharze, Acryl- sowie Methacylsäureester-Copolymere wie Copolymere des Methylmethacrylats mit Acrylsäure, Methacrylsäure, Acrylamid und/oder Hydroxyalkyl(meth)acrylaten, und elastomere Dien-Polymere und -Copolymere wie Blockcopolymere aus Butadien- und/oder Isopren-Homopolymerblöcken und Polymerblöcken aus Styrol oder $\alpha$-Methylstyrol sowie Ethylen-Elastomere, wie z.B. in DE-A-3 540 950 beschrieben. Sie liegen in den reliefbildenden Schichten üblicherweise in Mischung mit ein oder mehreren damit verträglichen photopolymerisierbaren ein- oder mehrfach ethylenisch ungesättigten Verbindungen vor, deren Art und Menge sich nach Art der Polymerbindemittel und Art der beabsichtigten Verwendung der lichtempfindlichen Mehrschichtmaterialien richten.

Das Mengenverhältnis in der Mischung von Monomeren und polymerem Bindemittel ist dabei in weitem Umfang variierbar, es beträgt bevorzugt 10 bis 55 und insbesondere 25 bis 50 Gew.% an Monomeren und 45 bis 90 und insbesondere 50 bis 75 Gew.% an polymerem Bindemittel, bezogen auf die Summe der Mengen von Monomeren und polymeren Bindemitteln. Die bevorzugten reliefbildenden Schichten sind bei Raumtemperatur fest und haben im allgemeinen Stärken von 200 bis 1200$\mu$m. Der Gehalt an bekannten Fotoinitiatoren, die bei Einwirkung von aktinischem Licht Radikale zu bilden vermögen, beträgt im allgemeinen 0,01 bis 15 Gew.% der Gesamtmenge der reliefbildenen Schicht.

Beispiele für besonders bevorzugte polymere Bindemittel für die reliefbildende Schicht sind
Polyvinylalkohole mit einem Restacetatgehalt von 10 bis 30 Mol% und einem mittleren Molekulargewicht $\overline{M}_w$ von ca. 10.000 bis ca. 30.000,
innerlich weichgemachte Polyvinylalkohole auf Basis von Polyethylenoxid-Polyvinylalkohol-Pfropfcopolymerisaten, wie sie bereits für die Herstellung der Zwischenschicht genannt wurden (vgl. EP-A-224 164),
alkohollösliche Mischpolyamide, z.B. solche aus etwa gleichen Teilen Hexamethylendiammoniumadipat, 4,4′-Diammonium-dicyclohexylmethanadipat und $\epsilon$-Caprolactam,
zu 80 Mol.% teilverseifte und zu etwa 3 Mol.% der freien OH-Gruppe mit Methacrylsäure veresterte Polyvinylalkohole (z.B. nach DE-A-33 22 993 hergestellt),
Copolymere, insbesondere Ter- oder Quaterpolymere aus Ethylen, (Meth)acrylsäure und Estern der Acrylsäure, wie z.B. n-Butylacrylat (z.B. nach DE-A-35 40 950 hergestellt).

Beispiele für in der reliefbildenden Schicht mitzuverwendende olefinisch ungesättigte photopolymerisierbare Verbindungen sind Verbindungen mit mindestens einer photopolymerisierbaren olefinisch ungesättigten Doppelbindung. Hierbei lassen sich die bekannten für die Herstellung von Reliefformen und Photopolymerhoch-, -tief- und -offset-druckplatten verwendeten Monomeren, Oligomeren und ungesättigten Polymeren verwenden, deren Art sich nach dem Verwendungszweck der Mischungen, aber auch nach der Art der anderen Mischungskomponenten richtet. In Frage kommen Monomere mit zwei oder mehr olefinisch ungesättigten photopolymerisierbaren Doppelbindungen allein oder in Mischung mit Monomeren mit nur einer olefinisch ungesättigten photopolymerisierbaren Doppelbindung. Auch Polymere mit mehreren seiten- oder endständigen olefinisch ungesättigten Doppelbindungen sind anstelle von oder in Mischung mit den Monomeren verwendbar. Beispiele geeigneter Monomerer sind die Di- und Polyacrylate und -methacrylate, wie sie durch Veresterung von Diolen oder Polyolen mit Acrylsäure oder Methacrylsäure hergestellt werden können; wie die Di- und Tri(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Neopentylglykol, (2,2-Dimethylpropandiol), 1,4-Butandiol, 1,1,1-Trimethylolpropan, Glycerin oder Pentaerythrit, ferner die Monoacrylate und Monomethacrylate solcher Diole und Polyole, wie z.B. Ethylenglykol-, Di-, Tri- oder Tetraethylenglykolmonoacrylat, Monomere mit zwei-oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid oder die (Meth)acrylate von Monoalkoholen mit 1 bis 6 C-Atomen.

Geeignete Monomere sind außerdem Umsetzungsprodukte von Glycidylethern mit Acrylsäure oder Methacrylsäure, wie z.B. Umsetzungsprodukte von Bisphenol-A-diglycidylether oder Butandioldiglycidylether mit Acrylsäure oder Methacrylsäure.

Als Photoinitiatoren und als Inhibitoren gegen die thermische Polymerisation eignen sich für die reliefbildende Schicht die bereits oben für die Herstellung der Zwischenschicht genannten, wobei auch hier jeweils in etwa die gleichen Mengenangaben gelten (d.h. 0,01 bis 10, vorzugsweise 0,01 bis 3 Gew.% Photoinitiator und 0,001 bis 3, vorzugsweise 0,003 bis 1 Gew.% Inhibitor, jeweils bezogen auf die Gesamtmenge der polymerisierbaren Schicht).

Als gegebenenfalls in der reliefbildenden Schicht mitzuverwendende Weichmacher kommen die üblichen in Frage, z.B. Benzolsulfonsäure-N-n-butylamid, Benzolsulfonamid, oder mehrwertige Alkohole, wie Glycerin oder OH-gruppenhaltige Polyether, Aminoalkohole, z.B. Triethanolamin oder handelsübliche Phthalsäureester, die in Mengen von 0 bis 30 Gew.%, bezogen auf das Trockengewicht der reliefbildenden Schicht eingesetzt werden können.

Die photopolymerisierbare reliefbildende Schicht kann auch noch ein Reglersystem enthalten, wie es beispielsweise in EP-A-114 341 beschrieben ist.

Dies sind Mischungen bestimmter Farbstoffe (1) mit milden Reduktionsmitteln (2) für den mitverwendeten jeweiligen Farbstoff (1) (vgl. auch EP-A-0 114 341). Die Mischung (1) + (2) soll bei der bildmäßigen

Belichtung mit aktinischem Licht keine merkliche Photopolymerisation in der Schicht der photopolymerisierbaren Mischung auslösen, was mit wenigen Versuchen feststellbar ist. Beträgt z.B. die Belichtungszeit für erfindungsgemäße, bevorzugt im wesentlichen lösungsmittelfreie, Schichten der photopolymerisierbaren, den Photoinitiator enthaltenden Mischung X Stunden oder Minuten, so sollte die entsprechende Schicht, die den Photoinitiator nicht enthält, mit Vorteil auch bei Anwendung der zehnfachen Belichtungszeit beim anschließenden Entwickeln der Reliefform durch Auswaschen keine merklichen Anteile an photopolymerisierter Schicht aufweisen, im allgemeinen sollten weniger als 20 Gew.% der belichteten Monomerenmengen photopolymerisiert sein.

Als Farbstoffe (1) für die photopolymerisierbaren Mischungen der reliefbildenden Schicht eignen sich vor allem solche aus der Reihe der Phenoxazinfarbstoffe, wie z.B.

Capriblau GN (C.I. 51000), Zaponechtblau 3 G (C.I. 51005), Galloblau E (C.I. 51040), Echtneublau 3 R (C.I. 51175), Nilblau A (C.I. 51180), Echtgrün M (C.I. 51210), Echtschwarz L (C.I. 51215), sowie Rhodanilblau, dem Salz bzw. Amid aus Rhodamin B (Basic Violet 10, C.I. 45170) und Nilblau (Basic Blue 12, C.I. 51180), Verbindungen aus der Reihe der Phenaziniumfarbstoffe, wie z.B. Neutralrot (C.I. 50040), Neutralviolett (C.I. 50030), Azinscharlach G (C.I. 50045), Rhodulinheliotrop 3 B (C.I. 50055), Neutralblau C (C.I. 50150), Azingrün GB (C.I. 50155), Safranin B (C.I. 50200), Indaminblau B (C.I. 50204), Rhodulinrot G (C.I. 50215), Rhodulinblau GG extra (C.I. 50220), Indazin GB (C.I. 50221), Safranin T (C.I. 50240), Mauvein (C.I. 50245), Naphthylrot (C.I. 50370) sowie Nigroinschwarz T (C.I. 50415), Acridiniumfarbstoffe, wie z.B. Acriflavin (C.I. 46000), Acridinorange (C.I. 46005), Acridinscharlach J (C.I. 46015), Acridingelb G (C.I. 46025), Aurazin G (C.I. 46030), Diamantphosphin GG (C.I. 46035), Phosphin E (C.I. 46045), Flaveosin (C.I. 46060), Benzoflavin (C.I. 46065) und Rheonin A (C.I. 46075), ferner Phenothiaziniumfarbstoffe, wie z.B. Methylenblau oder Thionin. Ebenso eignet sich (Isobutylthio)anthrachinon als Farbstoff (1).

Die Auswahl des in der photopolymerisierbaren Mischung verwendeten Farbstoffs (1) wird vor allem vom ästhetischen Eindruck mitbestimmt. So ist z.B. eine visuelle Beurteilung der Druckplatten besonders einfach mit den Verbindungen Neutralrot (C.I. 50040), Safranin T (C.I. 50240) sowie Rhodanilblau, die bevorzugt in der photopolymerisierbaren Mischung verwendet werden.

Die lichtempfindlichen reliefbildenden Schichten können also in Kombination mit dem Farbstoff (1) eine für diesen hinreichende Menge eines Reduktionsmittels (2) für den Farbstoff (1) enthalten, das den mitverwendeten Farbstoff (1) in Abwesenheit von aktinischem Licht nicht reduziert, bei Belichtung den Farbstoff im angeregten Elektronenzustand jedoch reduzieren kann, insbesondere zum Semichinon. Beispiele solcher milden Reduktionsmittel sind Ascorbinsäure, Anethol, Thioharnstoff, Diethylallylthioharnstoff, Hydroxylamin-derivate, insbesondere N-Allylthioharnstoff und bevorzugt Salze des N-Nitrosocyclohexylhydroxylamins,insbesondere die Kalium- und Aluminiumsalze. Letztere sind auch als Inhibitoren gegen die thermische Polymerisation in photopolymerisierbaren Mischungen bekannt. Die Menge der zugesetzten Reduktionsmittel beträgt im allgemeinen etwa 0,005 bis 5 und insbesondere 0,01 bis 1 Gew.%, bezogen auf die Gesamtmenge der photopolymerisierbaren Schicht, soll jedoch nicht weniger als das Reduktionsäquivalent der Menge des verwendeten Farbstoffs (1) betragen. In vielen Fällen hat sich der Zusatz des 3- bis 10-fachen der Menge an mitverwendetem Farbstoff (1) bewährt.

Die Herstellung der photopolymerisierbaren Druckplatten erfolgt im allgemeinen durch Aufbringen einer homogenen Mischung der Komponenten der photopolymerisierbaren Reliefschicht, gegebenenfalls unter Zusatz von Lösungsmittel oder Lösungsmittelgemischen auf den mit mindestens einer Haft(= Zwischen-)schicht versehenen dimensionsstabilen Träger.

Das homogene photopolymerisierbare Gemisch der reliefbildenden Schicht läßt sich auf übliche Weise durch Mischen der Einzelkomponenten in üblichen Mischaggregaten, beispielsweise in Knetern, Extrudern oder Rührkesseln herstellen. Das homogene Gemisch wird dann im allgemeinen in einer Dicke von 25 bis 6000, vorzugsweise 200 bis 1000 µm auf den mit der Haftschicht bzw. mit einer oder mehreren Zwischenschichten versehenen dimensionsstabilen Träger aufgebracht.

Es kann auch vorteilhaft sein, auf die photopolymerisierbare reliefbildende Schicht noch eine Deck- bzw. Schutzschicht aufzubringen, z.B. eine dünne Schicht aus im Entwicklermedium löslichen Polymeren, wie z.B. Polyvinylalkohol oder Polyvinylalkohol-Polyethylenoxid-Copolymerisate.

Die erfindungsgemäßen photopolymerisierbaren Druckplatten lassen sich in bekannter Weise zu Reliefformen, insbesondere Druckformen, verarbeiten. Hierzu wird im allgemeinen die Schicht des photoempfindlichen Materials bildmäßig mit aktinischem Licht aus Lichtquellen, wie UV-Fluoreszenzröhren, Quecksilberhoch-, -mittel- oder -niederdruckstrahlern, Leuchtstoffröhren etc. belichtet, wobei die emittierte Wellenlänge bevorzugt zwischen 300 und 420 nm liegt. Das Entfernen der unbelichteten und unvernetzten Schichtanteile kann durch Sprühen, Waschen, Bürsten etc. mit wäßrigen Lösungsmitteln oder Wasser erfolgen. Es ist ein Vorteil der erfindungsgemäßen Druckplatten, daß sie ein Auswaschen der unbelichteten Schichtteile mit reinem Wasser ohne Zusatz organischer Lösungsmittel erlauben. Zweckmäßig werden

entwickelte Relief- und Druckformen bei Temperaturen bis zu 120°C getrocknet und gegebenenfalls gleichzeitig oder danach mit aktinischem Licht nachbelichtet.

Die aus erfindungsgemäßen Aufzeichnungsmaterialien hergestellten Druckformen eignen- sich besonders für den direkten und indirekten Hochdruck, z.B. für den Flexodruck, Zeitungsflexodruck und ähnliche Druckarten.

Die erfindungsgemäßen Druckplatten, die in der Zwischen- bzw. Haftschicht eine Verbindung der allgemeinen Formel (I), insbesondere Phenylglycidylether(meth)acrylat als photopolymeriserbare ethylenische ungesättigte Verbindung enthalten, lassen sich sehr vorteilhaft herstellen und zu Druckformen verarbeiten, die eine wesentlich verbesserte Haftung der Reliefschicht auf dem Trägermaterial sowie eine deutlich verkürzte Mindestbelichtungszeit bei der Herstellung der Druckformen aufweisen.

Die Erfindung wird durch die nachstehenden Beispiele erläutert. Die darin genannten Teile und Prozente beziehen sich, soweit nicht anders angegeben, auf das Gewicht. Volumenteile verhalten sich zu Teilen wie Liter zu Kilogramm.

Beispiel 1

a) Herstellung der reliefbildenden Schicht:

50 Teile eines innerlich weichgemachten Polyvinylalkohols auf Basis eines Polyethylenoxid-Polyvinylalkohol-Pfropfcopolymerisats (Viskosität der 4 %igen Lösung in Wasser bei 25°C 4 mPas; z.B. Mowiol 04-M1 der Firma Hoechst AG), 50 Teile Phenylglycidyletheracrylat, 1,2 Teile Benzildimethylketal, 0,5 Teile Kaliumsalz des N-Nitrosocyclohexylhydroxylamins und 0,05 Teile Safranin T (C.I. 50240) werden durch Rühren bei 60°C in 50 Teilen Wasser und 50 Teilen Methanol gelöst. Die so erhaltene Lösung wird auf eine Polyesterfolie gegossen und so abgerakelt, daß nach einer Stunde Trocknen bei bis zu 100°C eine Schicht von 0,5 mm Dicke entsteht.

b) Herstellung der Zwischen- bzw. Haftschicht:

Auf eine 0,25 mm dicke, mit Trichloressigsäure geätzte Polyesterfolie wird Phenylglycidyletheracrylat, das 0,5 % des Kaliumsalzes von N-Nitrosocyclohexylhydroxylamin und 2 % Benzildimethylketal gelöst enthält, so aufgegossen, daß nach Abrakeln und 2 Minuten Belichten mit UV-Leuchtstoff-Röhren (oder: mit aktinischem Licht) unter Stickstoffatmosphäre eine Schicht von 0,02 mm Dicke und klebfreier Oberfläche entsteht.

Die unter a) erhaltene reliefbildende Schicht wird unter Verwendung eines Gemisches aus Ethanol und Wasser (1:1) mit dem so präparierten Träger kaschiert und die erhaltene Rohplatte einige Tage gelagert.

Nach Abziehen der Schutzfolie wird daraus auf dem üblichen Wege ein Klischee mit sehr guter Haftung der Reliefteile zum Träger hergestellt. Die Haftung kann nach dem üblichen Verfahren nicht gemessen werden, da die photopolymere Reliefschicht vor Erreichen der Haftgrenze reißt.

Beispiel 2

a) Herstellung der reliefbildenden Schicht:

50 Teile eines handelsüblichen alkohollöslichen Mischpolyamids aus etwa gleichen Teilen Hexamethylendiammoniumadipat, 4,4′-Diammonium-dicyclohexylmethanadipat und ε-Caprolactam mit einem K-Wert (nach Fickentscher) von 68 (z.B. ®Ultramid 1C der BASF AG) werden zusammen mit 25 Teilen Phenylglycidyletheracrylat, 25 Teilen Trimethylolpropantriacrylat, 0,3 Teilen des Kaliumsalzes von N-Nitrosocyclohexylhydroxylamins und 2 Teilen Benzildimethylketal in 90 Teilen Methanol und 10 Teilen Wasser gelöst und die Lösung, wie unter Beispiel 1 beschrieben, zu einer photopolymerisierbaren Reliefschicht verarbeitet.

b) Herstellung der Zwischen- bzw. Haftschicht:

Auf eine 0,25 mm dicke, mit Trichloressigsäure geätzte Polyesterfolie wird Phenylglycidyletheracrylat, das 5 % eines teilacetalisierten Polyvinylalkohols (enthaltend ca. 20 Gew.% Vinylalkohol-, ca. 1 Gew.% Vinylacetat- und 80 Gew.% Vinylbutyraleinheiten; K-Wert (nach Fikentscher, Cellulose Chem. 13, 58 (1932)) 44, 0,5 % des Kaliumsalzes von Nitrosocyclohexylhydroxylamin und 2 % Benzildimethylketal gelöst enthält, aufgegossen, die Gießschicht 1 Minute mit aktinischem Licht vorbelichtet, mit einer 0,05 mm dicken Polyethylenfolie kaschiert und durch 2 Minuten Belichten mit aktinischem Licht ausgehärtet.

Diese nach Abziehen der Polyethylenfolie klebfreie Schicht wird unter Verwendung eines Gemisches von Ethanol und Wasser (1:1) mit der Reliefschicht kaschiert und die erhaltene Rohplatte einige Tage gelagert.

Die nach dem Abziehen der Schutzfolie daraus auf dem üblichen Wege hergestellte Druckplatte zeichnet sich durch ausgezeichnete Haftung der Reliefschicht zum Träger aus. Beim Versuch, die Reliefschicht von der Trägerfolie zu lösen, spleißt die Polyesterfolie auf.

Beispiel 3

Trägerbleche aus 1,05 mm dickem Aluminiumblech und aus 0,24 mm dickem Stahlblech wurden mit dem im folgenden beschriebenen zweischichtigen Haftlack lackiert, um die Reliefschichten photopolymerisierbarer Hochdruckplatten mit Bindemitteln aus Polyamid und aus Polyvinylalkohol auf den Metallträgern dauerhaft zu verankern.

3.1 Herstellung der Grundierlackschicht:

243 Teile eines handelsüblichen Epoxidharzes (hergestellt aus Bisphenol A und Epichlorhydrin) mit einem Epoxidäquivalent von ca. 0,02 (bezogen auf 100 g Harz), einem Molekulargewicht von ca. 5 500 und einem OH-Gehalt von 5,9 % sowie 150 Teile feinteiliges Rutil, 6 Teile feinteiliges Chromoxidgrün, 90 Teile Talkum und 20 Teile einer handelsüblichen Paste eines mit organischen Ammoniumbasen modifizierten Bentonits (z.B. Bentone® der Fa. National Lead Co.) werden mit einem Gemisch aus Butylacetat, Äthylglykolacetat und Xylol (Mischungsverhältnis 1/1/1) in einer Kugelmühle 2 Tage lang angerieben.

In den resultierenden Stammlack werden 346 Teile eines handelsüblichen Umsetzungsproduktes aus 1 Mol 1,1,1-Trimethylolpropan und 3 Molen Toluylendiisocyanat als Polyisocyanat in Form der 75 %igen Lösung in Xylol/Äthylglykolacetat (Mischungsverhältnis 1:1) eingemischt.

Der resultierende Grundierlack wird jeweils auf Aluminiumblech oder Stahlblech schichtförmig aufgegossen. Die Lackschicht wird 1 Stunde bei Raumtemperatur abgelüftet und danach 5 Minuten im Umlufttrockenschrank bei 180 °C eingebrannt. Die Trockenfilmstärke der resultierenden Grundierlackschicht beträgt ca. 18 µm.

3.2 Herstellung der zweiten Haftschicht bzw. Zwischenschicht:

150 Teile eines Copolyamids aus etwa gleichen Teilen Hexamethylendiammoniumadipat, 4,4'-Diammonium-di-cyclohexyl-methanadipat und ε-Caprolactam mit einem K-Wert (nach Fikentscher, Cellulosechemie 13 (1932) 58) von 67, 100 Teile Phenylglycidyletheracrylat und 5 Teile 2,4,6-Trimethylbenzoyldiphenylphosphinoxid werden in Methanol/Wasser (Gewichtsverhältnis 9/1) bei 60 °C unter Rühren eingetragen. Auf diese Art und Weise wird eine 10 %ige Lösung hergestellt, die mit einem Gießer so auf die mit der Grundierlackschicht versehenen Trägerbleche aufgetragen wird, daß eine Trockenfilmdicke der Zwischenschicht von ca. 0,005 mm resultiert. Nach 30-minütigem Ablüften bei Raumtemperatur wird 1,5 Minuten lang bei 150 °C in einem Durchlauf-Düsentrockner eingebrannt.

3.3 Auftragen der lichtempfindlichen reliefbildenden Schicht:

Einer 65 %igen Lösung eines Gemisches von 60 % des unter 3.2 angegebenen Copolyamids, 25 % des Diethers aus 1 Mol Ethylenglykol und 2 Molen N-Hydroxymethyl-acrylamid, 13,5 % Benzolsulfonamid und 1,5 % Benzointetrahydropyranylether werden 0,3 % des Kaliumsalzes des N-Nitrosocyclohexylhydroxylamins, 0,01 % eines schwarzen Farbstoffs (Colour-Index Nr. 12195) und 0,03 % 2-Butylthio-2-anthrachinon zugegeben. Die Lösung wird schichtförmig auf das gemäß 3.1 und 3.2 mit den Haftschichten versehene Aluminiumblech so aufgegossen, daß nach dem Trocknen bei etwa 70 °C eine lichtempfindliche reliefbildende Schicht mit einer Stärke von 200 µm entsteht.

3.4 Prüfung der photopolymerisierbaren Druckplatten

Die nach Beispiel 3.1 bis 3.3 hergestellten Druckplatten werden jeweils 1, 2, 3 ... bis 10 Minuten lang im engen Kontakt mit einem Filmnegativ eines 3 %igen Rastertonwertes der Rasterlinienweite 30 Linien pro Zentimeter belichtet. Als Belichtungsgerät wird ein handelsüblicher Druckplatten-Belichter mit superaktinischen UV-Leuchtstoffröhren als Lichtquelle verwendet. Es wird die Belichtungszeit ermittelt, die ausreicht, um bei einer um den Faktor 2 verlängerten Auswaschzeit (100% Überwaschung) die Rasterfelder fehlerfrei

zu reproduzieren. Diese Mindestbelichtungszeit bei Überwaschung ist bei konstanter Reliefschichtrezeptur umso besser je geeigneter das Haftlacksystem ist.

Die gemäß 3.3 hergestellten Druckplatten benötigen sowohl mit Aluminium-als auch mit Stahlträgerblech eine Mindestbelichtungszeit von 3,0 Minuten. Die Druckplatte wurde 6 Minuten lang bei 30 °C in einem Ethanol/Wasser-Gemisch (87 % Ethanol und 13 % Wasser) in einem handelsüblichen Sprühwascher bei 4 bar Sprühdruck ausgewaschen (also überwaschen) obwohl die erforderliche Mindestauswaschzeit nur 3,0 Minuten beträgt.

Beispiel 4

Es wird wie in Beispiel 3 beschrieben verfahren, jedoch enthält die Zwischenschicht (s. 3.2) keinen Photoinitiator. Die Prüfung gemäß 3.4 ergibt die geringfügig schlechtere Mindestbelichtungszeit von 3,75 Minuten.

Vergleichsversuch 1a

Es wird wie in Beispiel 3 verfahren, jedoch enthält die Zwischenschicht kein Phenylglycidyletheracrylat und keinen Photoinitiator. Die Prüfung der Druckplatten ergibt eine sehr schlechte Mindestbelichtungszeit von größer als 10 Minuten.

Vergleichsversuch 1b

Es wird wie in Beispiel 3 verfahren, jedoch enthält die Zwischenschicht anstelle von 100 Teilen Phenylglycidyletheracrylat 65 Teile eines härtbaren Phenolharzes (hergestellt durch Kondensation von 30 Teilen Phenol und 7,5 Teilen Bisphenol A mit überschüssigem Formaldehyd bei 100 °C in Gegenwart von Dimethylethanolamin). Das Einbrennen der Lackschicht erfolgt bei 180 °C und 5 Minuten Verweilzeit. Die Prüfung der Druckplatten ergibt die noch ungenügende Mindestbelichtungszeit von 8 Minuten.

Beispiel 5

5.1 Herstellung eines zweischichtigen Haftlackes

Die Grundierlackschicht wird wie unter Beispiel 3.1 beschrieben hergestellt. Zur Herstellung der zweiten Haftschicht (= Zwischenschicht) werden im Unterschied zu Beispiel 3 100 Teile zu 80 Mol-% teilverseifter und zu 3 Mol-% methacrylierter Polyvinylalkohol (Herstellung siehe DE-A-33 22 993) des mittleren Molekulargewichtes $\overline{M}_w$ = 17000. 110 Teile Phenylglycidyletheracrylat, 5 Teile Photoinitiator 2,4,6-Trimethylbenzoyldiphenylphosphinoxid sowie 3 Teile 30 %ige wäßrige Glyoxallösung in 60 °C warmem Wasser/n-Propanol(75/25)-Gemisch unter Rühren gelöst, um eine 14 %ige (Feststoffgehalt) Lacklösung herzustellen. Schichtdicke und Einbrennung sind mit den in 3.2 beschriebenen Werten identisch.

5.2 Herstellung der lichtempfindlichen reliefbildenden Schicht:

Eine 65 %ige Lösung von 60 Teilen zu 80 Mol-% teilverseiften und zu 3 Mol-% methacrylierten Polyvinylalkohols (gemäß DE-A-33 22 993 hergestellt) des mittleren Molekulargewichts $\overline{M}_w$ = 17000, 30 Teilen des Diethers aus 1 Mol Ethylenglykol und 2 Mol N-Hydroxymethylacrylamid, 7 Teilen N-n-Butylbenzolsulfonamid, 2 Teilen Benzildimethylketal, 0,03 Teilen Safranin T (C.I. 50240), 0,03 Teilen Kristallviolett (C.I. 42555) und 0,3 Teilen des Kaliumsalzes des N-Nitrosocyclohexylhydroxylamins wurde durch Lösen in einem Gemisch aus n-Propanol/Wasser (Mischverhältnis 25 : 75) von 60 °C hergestellt. Durch Aufgießen auf die unter 5.1 näher beschriebenen Trägerbleche aus Aluminium bzw. Stahl und Trocknen auf eine Lösemittel-Restfeuchte von 6 % wurden photopolymerisierbare Druckplattenschichten mit der Reliefschichtdicke 0,2 mm erhalten.

5.4 Prüfung der Druckplatten

Die Prüfung erfolgt exakt wie unter Beispiel 3.4 beschrieben. Anstelle des Auswaschmittels Ethanol/Wasser wird jedoch Leitungswasser von Raumtemperatur benutzt. Als normale Auswaschzeit werden 1,5 Minuten ermittelt. Die um den Faktor 2 verlängerte Auswaschzeit beträgt demnach 3 Minuten. Mit dieser Auswaschzeit werden die Testklischees hergestellt. Die Beurteilungskriterien der Klischees sind

mit den in Beispiel 3.4 beschriebenen identisch.

Die gemäß Beispiel 5.2 hergestellten Druckplatten benötigen sowohl auf Stahl- als auch auf Aluminiumträgerblech eine Mindestbelichtungszeit von 2,0 Minuten. Die Druckplatte wurde in einem Sprühwascher bei einem Sprühdruck von 4,5 bar und Raumtemperatur 3 Minuten lang (= verdoppelte Normalauswaschzeit) ausgewaschen. Auch unter diesen ungünstigen Bedingungen bleibt die Mindestbelichtungszeit bei 2,0 Minuten. Selbst eine Verdreifachung der Auswaschzeit auf 4,5 Minuten führt nicht zu einer Verschlechterung der Mindestbelichtungszeit. Setzt man anstelle des Phenylglycidyletheracrylats in der Haftschicht die entsprechende Menge Kresylglycidyletheracrylat ein, so erhält man ebenfalls eine Mindestbelichtungszeit von 2,0 Minuten.

Vergleichsversuch 3a

Es wird wie in Beispiel 5 verfahren, jedoch enthält die Haftschicht (= Zwischenschicht) kein Phenylglycidyletheracrylat und keinen Photoinitiator. Die Prüfung der Druckplatten ergibt eine sehr schlechte Mindestbelichtungszeit von größer als 10 Minuten.

Beispiel 6

Es werden Druckplattenträgerbleche wie unter Beispiel 5.1 bis 5.2 beschrieben hergestellt. Die Schichtdicke der Zwischenschicht beträgt statt 0,005 mm jedoch 0,03 mm. Um diese Haftschicht nicht bereits thermisch zu polymerisieren, wird sie statt bei 150 °C im Düsentrockner innerhalb von 5 Minuten in einem Umlufttrockenschrank getrocknet. Die Vernetzung dieser Haft-(= Zwischen-)schicht wird photochemisch durch eine Belichtung in einem Durchlauf-Röhren-Belichter, der mit superaktinischen Leuchtstoffröhren als UV-A-Lichtquelle ausgestattet ist, bei einer Verweilzeit von 60 Sekunden bewirkt.

Eine 65 %ige Lösung von 60 Teilen zu 80 Mol-% teilverseiften und zu 3 Mol-% methacrylierten Polyvinylalkohols (gemäß DE-A-3 22 993 hergestellt) des mittleren Molekulargewichtes $\overline{M}_w$ = 17 000, 30 Teilen des Diesters aus 1 Mol 1,4-Butandioldiglycidylether und 2 Mol Acrylsäure, 2 Teilen Benzildimethylketal, 0,03 Teilen Safranin T (C.I. 50240), und 0,3 Teilen des Kaliumsalzes des N-Nitrosocyclohexylhydroxylamins wurde durch Lösen in einem Gemisch aus n-Propanol/Wasser (Mischverhältnis 1/3) von 60 °C hergestellt. Durch Aufgießen auf die unter 5.1 näher beschriebenen Trägerbleche aus Aluminium bzw. Stahl und Trocknen auf eine Lösemittel-Restfeuchte von 6 % wurden photopolymerisierbare Druckplattenschichten mit der Reliefschichtdicke 0,7 mm erhalten.

Diese Druckplatten erfordern bei der Normalauswaschzeit von 6 Minuten bei 40 °C und 4,0 bar Sprühdruck eine Mindestbelichtungszeit von 5,0 Minuten, die sich auch bei verdoppelter Auswaschzeit nicht merklich verschlechtert.

Vergleichsversuch 4

Es wird wie in Beispiel 6 verfahren, jedoch enthält die Zwischenschicht kein Phenylglycidyletheracrylat. Die Prüfung der Druckplatten ergibt eine sehr schlechte Mindestbelichtungszeit von größer als 10 Minuten.

Beispiel 7

Es werden Druckplattenträgerbleche wie unter Beispiel 5.1 bis 5.2 beschrieben hergestellt. Die Schichtdicke der Zwischenschicht beträgt statt 0,005 mm jedoch 0,01 mm. Um diese Zwischenschicht nicht bereits thermisch zu polymerisieren, wird sie jedoch statt bei 150 °C bei 110 °C im Düsentrockner getrocknet. Die Vernetzung dieser Haftschicht wird photochemisch erst während der Verarbeitung zum Klischee durch den Verarbeitungsschritt der vollflächigen Vorbelichtung bewirkt.

Zur Herstellung der Druckplatte wird eine 65%ige Lösung von 50 Teilen eines zu 80 Mol-% teilverseiften Polyvinylalkohols des mittleren Molekulargewichtes $\overline{M}_w$ = 17 000, 40 Teilen Hydroxiethylmethacrylat, 1 Teil 1,3,5-Trimethylbenzoyldiphenylphosphinoxid und 0,3 Teilen Hydrochinonmonomethylether durch Lösen in n-Propanol/Wasser (Mischungsverhältnis 1/3) von 60 °C hergestellt. Durch Aufgießen auf die unter 5.1 näher beschriebenen Trägerbleche aus Aluminium bzw. Stahl und Trocknen auf eine Lösemittel-Restfeuchte von 6 % wurden photopolymerisierbare Druckplattenschichten mit der Reliefschichtdicke 0,5 mm erhalten.

Diese Druckplatten erfordern bei der Normalauswaschzeit von 2,5 Minuten bei 40 °C und 4,0 bar Sprühdruck und einer vollflächigen Vorbelichtung von 3,5 Sekunden eine Mindesthauptbelichtungszeit von 1,5 Minuten, die sich auch bei verdoppelter Auswaschzeit nicht merklich verschlechtert.

Vergleichsversuch 5

Es wird wie in Beispiel 7 verfahren, jedoch enthält die Zwischenschicht kein Phenylglycidyletheracrylat. Die Prüfung der Druckplatten bei verdoppelter Auswaschzeit ergibt eine Mindesthauptbelichtungszeit von 6 Minuten, wobei andere Bildelemente, insbesondere feine Linien und Punkte noch längere Belichtungszeiten erfordern.

Beispiel 8

8.1 Herstellung der Grundierlackschicht

Trägerbleche aus 1,05 mm dickem Aluminiumblech und aus 0,24 mm dickem Stahlblech wurden wie unter Beispiel 3.1 beschrieben, zunächst mit einer Grundierlackschicht versehen.

8.2 Herstellung der Zwischenschicht

Auf diese mit einer Grundierlackschicht versehenen Trägerbleche, wurde eine 20%ige Lösung eines Gemisches, bestehend aus 49 Teilen eines carboxylgruppenhaltigen Acrylatharzes SZ: 75; MG: 30 000; $T_G$: 42 ° C; z.B. Carboset resin XL 44 der Firma BF Goodrich), 49 Teilen Phenylglycidyletheracrylat und 2 Teilen Benzildimethylketal schichtförmig aufgegossen. Die aufgetragene Lackschicht wurde 1 Stunde bei Raumtemperatur abgelüftet und 5 Minuten bei 160 ° C eingebrannt. Die erhaltene Trockenfilmstärke der resultierenden Haftschicht betrug 10 $\mu$m.

8.3 Auftragen der lichtempfindlichen reliefbildenden Schicht:

Eine lichtempfindliche Schicht, bestehend aus 80 Teilen eines Terpolymeren (aus 60 % Ethylen, 20 % Acrylsäure und 20 % n-Butylacrylat, melt flow index ca. 300), 15 Teilen Hexandioldiacrylat, 10 Teilen Benzolsulfosäurebutylamid,2 Teilen Benzildimethylketal und 0,4 Teilen Hydrochinonmonomethylether wird auf die Zwischenschicht aufkaschiert und das resultierende Mehrschichtmaterial 3 Tage bei Raumtemperatur gelagert.

8.4 Prüfung der Mehrschichtenmaterialien

Die lichtempfindliche Schicht wurde bildmäßig belichtet und mit 1 %iger Sodalösung entwickelt. Es zeigte sich, daß die aufgetragene Zwischenschicht eine hervorragende Haftung sowohl zum Grundierlack als auch zur photopolymerisierten Reliefschicht besaß. Es war nicht möglich, Teile des erzeugten Reliefs vom Stahlträger abzuziehen. Sowohl Primär- als auch Sekundärhaftung der Haftschicht (= Zwischenschicht) waren größer als die Kohäsion der photopolymerisierten Reliefschicht.

Beispiel 9

Es wurde wie in Beispiel 8 verfahren, nur daß an Stelle des in der Zwischenschicht verwandten carboxylgruppenhaltigen Acrylatharzes, das unter 8.3 beschriebene Terpolymerisat (Ethylen/Acrylsäure/n-Butylacrylat) eingesetzt wurde. Auch hier zeigte sich, daß die Zwischenschicht eine ausgezeichnete Haftung zum Grundierlack wie zur photopolymerisierten Reliefschicht ausbildet. Auch in diesem Beispiel erwies sich die Primär- und Sekundärhaftung größer als die Kohäsion der Reliefschicht.

**Patentansprüche**

**1.** Lichtempfindliche, photopolymerisierbare, zur Herstellung von Druckformen geeignete Druckplatte die auf einem dimensionsstabilen Träger mindestens eine Zwischenschicht und darauf eine reliefbildende lichtempfindliche Schicht trägt, die im wesentlichen aus einem Gemisch aus polymerem Bindemittel, mindestens einer ethylenisch ungesättigten polymerisierbaren Verbindung, Photoinitiator und thermischem Polymerisationsinhibitor besteht, dadurch gekennzeichnet, daß mindestens eine Zwischenschicht eine Verbindung der allgemeinen Formel (I)

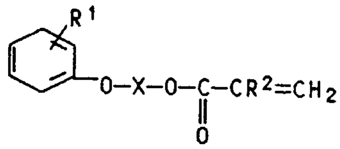

(I)

worin $R^1$ für Wasserstoff oder einen Alkylrest mit 1 bis 10 Kohlenstoffatomen,
$R^2$ für Wasserstoff oder einen Methylrest,
und X für
$-C_2H_4-$, $-(CH_2-CH_2-O)_n-C_2H_4-$ ,
$-(CHCH_3-CH_2-O)_n-CHCH_3-CH_2-$ ,

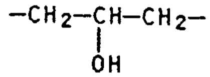 oder 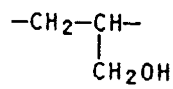

und n = 1 bis 8 stehen, in im wesentlichen ausgehärteten Zustand enthält.

**2.** Druckplatte nach Anspruch 1, dadurch gekennzeichnet, daß auf dem dimensionsstabilen Träger als erste Zwischenschicht eine dünne Schicht eines üblichen Haftvermittlers und darauf eine zweite Zwischenschicht vorhanden ist, die eine Verbindung der allgemeinen Formel (I) im Gemisch mit polymerem Bindemittel in im wesentlichen ausgehärteten Zustand enthält.

**3.** Druckplatte nach Anspruch 1 oder 2, dadurch gekennzeichnet, daß mindestens eine Zwischenschicht aus einer Verbindung der allgemeinen Formel (I) in im wesentlichen ausgehärteten Zustand besteht.

**4.** Druckplatte nach Anspruch 1 oder 2, dadurch gekennzeichnet, daß mindestens eine Zwischenschicht aus einem Gemisch einer Verbindung der allgemeinen Formel (I) mit einem damit verträglichen polymeren Bindemittel besteht, wobei die Verbindung der allgemeinen Formel (I) in im wesentlichen ausgehärteten Zustand vorliegt.

**5.** Druckplatte nach Anspruch 4, dadurch gekennzeichnet, daß als polymeres Bindemittel Polyvinylalkohol oder ein Derivat des Polyvinylalkohols eingesetzt wird.

**6.** Druckplatte nach Anspruch 4, dadurch gekennzeichnet, daß als polymeres Bindemittel ein Polyamid eingesetzt wird.

**7.** Druckplatte nach Anspruch 4, dadurch gekennzeichnet, daß als Bindemittel ein Ethylen/(Meth)-acrylsäureester/(Meth)acrylsäure-Copolymerisat eingesetzt wird.

**8.** Druckplatte nach einem der vorhergehenden Ansprüche, dadurch gekennzeichnet, daß die reliefbildende lichtempfindliche Schicht mit einer abziehbaren Schutzfolile bedeckt ist.

**9.** Druckplatte nach einem der vorhergehenden Ansprüche, dadurch gekennzeichnet, daß in der Formel (I) $R^1$ für Wasserstoff oder Methyl und X für den Rest

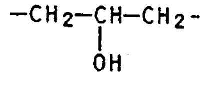

stehen.

**10.** Verfahren zur Herstellung einer lichtempfindlichen photopolymerisierbaren Druckplatte nach einem der vorhergehenden Ansprüche, dadurch gekennzeichnet, daß eine Lösung, die eine Verbindung der allgemeinen Formel (I) enthält, als Zwischenschicht auf den dimensionsstabilen Träger aufgetragen, nach weitgehender Entfernung des Lösungsmittels die als Relief bildende lichtempfindliche Schicht

aufgebracht und dann der erhaltene Schichtaufbau solange vollflächig belichtet wird, daß die Zwischenschicht aushärtet, ohne daß die in der das Relief bildende Schicht enthaltenen ethylenisch ungesättigten polymerisierbaren Verbindungen in wesentlichem Umfang polymerisieren.

## Claims

**1.** A light-sensitive photopolymerizable laminate material suitable for producing printing plates which on a dimensionally stable base carries at least one intermediate layer and on top thereof a relief-forming light-sensitive layer which consists essentially of a mixture of polymeric binder, at least one ethylenically unsaturated polymerizable compound, photoinitiator and thermal polymerization inhibitor, wherein at least one intermediate layer contains a compound of the general formula (I)

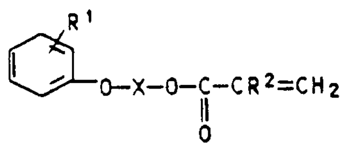

(I)

where $R^1$ is hydrogen or alkyl of from 1 to 10 carbon atoms,
$R^2$ is hydrogen or methyl,
and X is
$-C_2H_4-$, $-(CH_2-CH_2-O)_n-C_2H_4-$ ,
$-(CHCH_3-CH_2-O)_n-CHCH_3-CH_2-$ ,

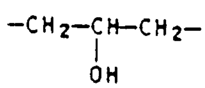 or 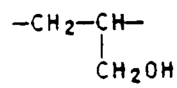

where n is from 1 to 8, in a substantially cured state.

**2.** A laminate as claimed in claim 1, wherein there is present on the dimensionally stable base material as a first intermediate layer a thin layer of a customary adhesion promoter and on top thereof a second intermediate layer which contains a compound of the general formula (I) mixed with a polymeric binder in a substantially cured state.

**3.** A laminate as claimed in claim 1 or 2, wherein at least one intermediate layer consists of a compound of the general formula (I) in a substantially cured state.

**4.** A laminate as claimed in claim 1 or 2, wherein at least one intermediate layer consists of a mixture of a compound of the general formula (I) with a polymeric binder compatible therewith, in which the compound of the general formula (I) is present in a substantially cured state.

**5.** A laminate as claimed in claim 4, wherein the polymeric binder used is polyvinyl alcohol or a derivative of polyvinyl alcohol.

**6.** A laminate as claimed in claim 4, wherein the polymeric binder used is polyamide.

**7.** A laminate as claimed in claim 4, wherein the binder used is an ethylene/(meth)acrylic ester/(meth)-acrylic acid copolymer.

**8.** A laminate as claimed in any of the preceding claims, wherein the relief-forming light-sensitive layer has been covered with a cover sheet removable by peeling.

**9.** A laminate as claimed in any of the preceding claims, wherein in the formula (I) $R^1$ is hydrogen or methyl and X is

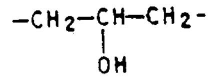

**10.** A process for producing a light-sensitive photopolymerizable laminate material as claimed in any of the preceding claims, which comprises applying a solution which contains a compound of the general formula (I) as an intermediate layer to the dimensionally stable base, substantially removing the solvent, applying the relief-forming light-sensitive layer and then subjecting the layered structure obtained to uniform exposure until the intermediate layer is fully cured without polymerizing the ethylenically unsaturated polymerizable compounds present in the relief-forming layer to any significant extent.

**Revendications**

**1.** Plaque d'impression photopolymérisable sensible à la lumière convenant pour la fabrication de formes d'impression, qui porte, sur un support à dimensions stables, au moins une couche intermédiaire et, sur celle-ci, une couche photosensible formant le relief laquelle consiste essentiellement en un mélange d'un liant polymère, d'au moins un composé à insaturation éthylénique polymérisable, un photo-inducteur et un inhibiteur de la polymérisation à la chaleur, caractérisée par le fait qu'au moins une couche intermédiaire contient un composé de formule générale I

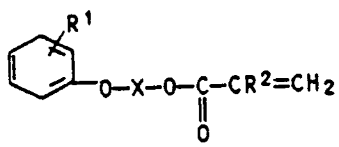

(I)

dans laquelle $R^1$ représente l'hydrogène ou un groupe alkyle en C1-C10,
$R^2$ représente l'hydrogène ou un groupe méthyle, et X représente
$-C_2H_4-$, $-(CH_2-CH_2-O)_n-C_2H_4-$,
$-(CHCH_3-CH_2-O)_n-CHCH_3-CH_2-$,

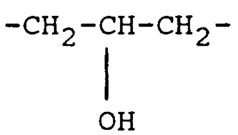 ou 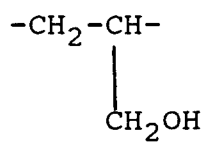

et n = 1 à 8,
à l'état essentiellement durci.

**2.** Plaque d'impression selon la revendication 1, caractérisée par le fait qu'elle porte, sur le support à dimensions stables, une première couche intermédiaire consistant en une couche mince d'un agent d'adhérence usuel et, sur celle-ci, une deuxième couche intermédiaire contenant un composé de formule générale I en mélange avec un liant polymère à l'état essentiellement durci.

**3.** Plaque d'impression selon la revendication 1 ou 2, caractérisée par le fait qu'au moins une couche intermédiaire consiste en un composé de formule générale I à l'état essentiellement durci.

**4.** Plaque d'impression selon la revendication 1 ou 2, caractérisée par le fait qu'au moins une couche intermédiaire consiste en un mélange d'un composé de formule générale I et d'un liant polymère compatible avec celui-ci, le composé de formule générale I étant à l'état essentiellement durci.

**5.** Plaque d'impression selon la revendication 4, caractérisée par le fait que le liant polymère utilisé est l'alcool polyvinylique ou un dérivé de l'alcool polyvinylique.

**6.** Plaque d'impression selon la revendication 4, caractérisée par le fait que le liant polymère utilisé est un polyamide.

**7.** Plaque d'impression selon la revendication 4, caractérisée par le fait que le liant utilisé est un copolymère éthylène/ester (méth)acrylique/acide (méth)acrylique.

**8.** Plaque d'impression selon une des revendications qui précèdent, caractérisée par le fait que la couche photosensible formant le relief est recouverte d'une feuille de protection éliminable.

**9.** Plaque d'impression selon une des revendications qui précèdent, caractérisée par le fait que, dans la formule I, $R^1$ représente l'hydrogène ou un groupe méthyle et X le groupe

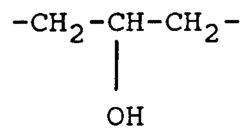

**10.** Procédé pour la préparation d'une plaque d'impression photopolymérisable sensible à la lumière selon l'une des revendications qui précèdent, caractérisé par le fait que l'on applique sur le support à dimensions stables, en couche intermédiaire, une solution contenant un composé de formule générale I, on applique ensuite, après élimination complète du solvant, la couche photosensible formant le relief puis on expose l'ensemble sur toute sa surface à la lumière pendant une durée suffisante pour que la couche intermédiaire durcisse complètement sans que les composés à insaturation éthylénique polymérisables contenus dans la couche formant le relief polymérisent dans une mesure notable.